# EUROPEAN PATENT APPLICATION

(11) **EP 1 986 249 A2**
(43) Date of publication of application: **29.10.2008**
(21) Application number: 08251202.1
(22) Date of filing: 28.03.2008
(51) Int. Cl.: H01L 51/52

(54) **Organic light emitting device and method of manufacturing the same**

(30) Priority: 23.04.2007 KR 20070039465
(71) Applicant: Samsung SDI Co., Ltd., Suwon-si, Gyeonggi-do (KR)
(72) Inventor: Kim, Yong-Tak, Suwon-si Gyeonggi-do (KR); Kim, Won-Jong, Suwon-si Gyeonggi-do (KR); Lee, Chang-Ho, c/o Y.P. Lee, Mock & Partners, Seocho-Gu, Seoul 137-875 (KR); Choi, Jin-Baek, Suwon-si Gyeonggi-do (KR); Lee, Jong-Hyuk, Suwon-si Gyeonggi-do (KR); Cho, Yoon-Yeung, c/o Y.P. Lee, Mock & Partners, Seocho-Gu, Seoul 137-975 (KR); Lee, Byoung-Duk, Suwon-si Gyeonggi-do (KR); Oh, Min-Ho, Suwon-si Gyeonggi-do (KR); Lee, So-Young, Suwon-si Gyeonggi-do (KR); Lee, Sun-Young, c/(o Y.P. Lee, ;ock & Partners, Seocho-Gu, Seoul 137-875 (KR); Song, Young-Woo, Suwon-si Gyeonggi-do (KR)
(74) Representative: Mounteney, Simon James

(57) **Abstract**

An organic light emitting device including an anode (2) having a high light transmissivity and a controllable work function, and allowing for a high degree of freedom for selection of a cathode (4), and a method of manufacturing the same. The anode of the organic light emitting device includes a first layer (21). The first layer (21) includes a first metal oxide, and a second metal oxide differing from the first metal oxide and doped into the first metal oxide. The cathode faces the anode, and an organic layer (3) including an emission layer between the anode and the cathode.

## Description

### BACKGROUND OF THE INVENTION

### 1. Field of the Invention

The present invention relates to an organic light emitting device and a method of manufacturing the same.

### 2. Description of the Related Art

An organic light emitting device is a self-emitting device that includes an anode, a cathode facing the anode, and an intermediate layer including an emission layer interposed between the anode and the cathode. Holes from the anode and electrons from the cathode are injected into the emission layer of the intermediate layer to generate excitons, thereby emitting light which is transmitted out of the organic light emitting device through one of the anode or the cathode. Accordingly, the anode or the cathode through which light is transmitted may have high transmissivity.

In addition, the anode of the organic light emitting device may have a higher absolute work function value than that of the cathode. The reason for this is because holes should be easily provided from the anode to the intermediate layer, and electrons should be easily provided from the cathode to the intermediate layer.

Due to this reason, in general, a conventional organic light emitting device includes an anode formed of Indium Tin Oxide (ITO) having sufficient transmissivity and relatively large absolute work function value. The absolute work function value can be further increased by subjecting ITO to an UV-O₃ treatment and/or N₂ plasma treatment.

However, a typical ITO anode has transmissivity of as low as 45%, and it is difficult to control the work function. These problems limit the function of the anode as a transparent electrode.

Also, in a top-emission type organic light emitting device in which an image is displayed in a direction of (or through) a cathode, the cathode should be formed of a material having a small absolute work function value and high transmissivity. However, it is difficult to obtain a material having a small absolute work function value and high transmissivity, so that a metal having a small absolute work function value, such as Mg:Ag, is used to form a semi-transparent layer, and then a conventional transparent electrode, such as ITO, is deposited thereon to compensate the conductivity. However, even such a conventional light transmissive cathode has low light transmissivity due to the limitation on the selection of a cathode-forming material. As described above, in a top-emission type organic light emitting device, it is difficult to obtain a cathode-forming material that can provide the desired difference between the work function of the anode and the work function of the cathode and to increase light transmissivity of the formed cathode.

### SUMMARY OF THE INVENTION

The present sets out to provide an organic light emitting device including an anode having high transmissivity and/or controllable work function, and a method of manufacturing the same.

The present invention also sets out to provide an organic light emitting device having high light transmissivity and/or controllable work function, and/or a high degree of freedom with respect to selection of a cathode, and a method of manufacturing the same.

Accordingly, a first aspect of the invention provides an organic light emitting device as set out in Claim 1. Preferred features of this aspect of the invention are set out in Claims 2 to 12.

A second aspect of the invention provides a method of manufacturing an organic light emitting device as set out in Claim 13. Preferred features of this aspect of the invention are set out in Claims 14 to 17.

An embodiment of the present invention provides an organic light emitting device. The organic light emitting device includes: an anode including a first layer, the first layer including a first metal oxide and a second metal oxide, the second metal oxide differing from the first metal oxide and doped into the first metal oxide; a cathode facing the anode; and an organic layer including an emission layer between the anode and the cathode.

In one embodiment, the anode further includes a second layer including a material selected from the group consisting of indium oxide, indium tin oxide, zinc oxide, indium zinc oxide, tin oxide, antimony tin oxide, antimony zinc oxide, aluminum oxide, and combinations thereof. The cathode may include a material selected from the group consisting of Ag, Mg, Al, Pt, Pd, Au, Ni, Nd, Ir, Cr, and compounds thereof. The anode may further include a third layer including a material selected from the group consisting of molybdenum oxide, vanadium oxide, tungsten oxide, nickel oxide, copper oxide, fullerene, metal-containing fullerene-based complex, carbon nano tube, carbon fiber, carbon black, graphite, carbine, MgC₆₀, SrC₆₀, CaC₆₀, C₆₀, and combinations thereof.

In one embodiment, the anode further includes a second layer including a material selected from the group consisting of molybdenum oxide, vanadium oxide, tungsten oxide, nickel oxide, and copper oxide, fullerene, metal-containing fullerene-based complex, carbon nano tube, carbon fiber, carbon black, graphite, carbine, MgC₆₀, SrC₆₀, CaC₆₀, C₆₀, and combinations thereof. The cathode may include a material selected from the group consisting of Ag, Mg, Al, Pt, Pd, Au, Ni, Nd, Ir, Cr, and compounds thereof.

In one embodiment, the cathode includes a material selected from the group consisting of Ag, Mg, Al, Pt, Pd, Au, Ni, Nd, Ir, Cr, and compounds thereof.

In one embodiment, the anode further includes a reflective layer including a material selected from the group consisting of Ag, Mg, Al, Pt, Pd, Au, Ni, Nd, Ir, Cr, and compounds thereof. The anode may further include a second layer including a material selected from the group consisting of indium oxide, indium tin oxide, zinc oxide, indium zinc oxide, tin oxide, antimony tin oxide, antimony zinc oxide, aluminum oxide, and combinations thereof.

In one embodiment, the anode includes: the first layer; a reflective layer including a material selected from the group consisting of Ag, Mg, Al, Pt, Pd, Au, Ni, Nd, lr, Cr, and compounds thereof; and a second layer including a material selected from the group consisting of indium oxide, indium tin oxide, zinc oxide, indium zinc oxide, tin oxide, antimony tin oxide, antimony zinc oxide, aluminum oxide, and combinations thereof, and the reflective layer is between the first layer and the second layer.

In one embodiment, the anode includes the first layer; a second layer including a material selected from the group consisting of indium oxide, indium tin oxide, zinc oxide, indium zinc oxide, tin oxide, antimony tin oxide, antimony zinc oxide, aluminum oxide, and combinations thereof; a reflective layer including a material selected from the group consisting of Ag, Mg, Al, Pt, Pd, Au, Ni, Nd, Ir, Cr, and compounds thereof; and a third layer including a material selected from the group consisting of indium oxide, indium tin oxide, zinc oxide, indium zinc oxide, tin oxide, antimony tin oxide, antimony zinc oxide, aluminum oxide, and combinations thereof, wherein the second layer is between the first layer and the reflective layer, and wherein the reflective layer is between the second layer and the third layer. Here, the second layer may be substantially the same in material composition as the third layer.

In one embodiment, the cathode includes a material selected from the group consisting of indium oxide, indium tin oxide, zinc oxide, indium zinc oxide, tin oxide, antimony tin oxide, antimony zinc oxide, aluminum oxide, and combinations thereof.

In one embodiment, the first metal oxide includes a material selected from the group consisting of indium oxide, indium tin oxide, zinc oxide, indium zinc oxide, tin oxide, antimony tin oxide, antimony zinc oxide, aluminum oxide, and combinations thereof.

In one embodiment, the second metal oxide includes a material selected from the group consisting of ytterbium oxide, lanthanum oxide, yttrium oxide, beryllium oxide, titanium oxide, silicon oxide, gallium oxide, palladium oxide, samarium oxide, and combination thereof.

Another embodiment of the present invention provides a method of manufacturing an organic light emitting device. The method includes: forming an anode; forming an intermediate layer including an emission layer on the anode; and forming a cathode on the intermediate layer, wherein the forming the anode includes forming a first layer to include a first metal oxide and a second metal oxide differing from the first metal oxide, and wherein the forming the first layer includes depositing the first metal oxide and doping a portion of the first metal oxide to form the second metal oxide.

In one embodiment, the first metal oxide includes a material selected from the group consisting of indium oxide, indium tin oxide, zinc oxide, indium zinc oxide, tin oxide, antimony tin oxide, antimony zinc oxide, aluminum oxide, and combinations thereof.

In one embodiment, the second metal oxide includes a material selected from the group consisting of ytterbium oxide, lanthanum oxide, yttrium oxide, beryllium oxide, titanium oxide, silicon oxide, gallium oxide, palladium oxide, samarium oxide, and combinations thereof.

In one embodiment, the depositing the first metal oxide includes plasma ionizing a metal to be deposited as the first metal oxide.

In one embodiment, the doping the portion of the first metal oxide to form the second metal oxide includes co-depositing a do pant into the first metal oxide.

### BRIEF DESCRIPTION OF THE DRAWINGS

The accompanying drawings, together with the following description, illustrate embodiments of the present invention, and serve to explain the principles of the present invention.

FIG. 1 is a schematic, sectional view of an organic light emitting device according to an embodiment of the present invention;

FIG. 2 is a schematic, sectional view of an organic light emitting device according to another embodiment of the present invention;

FIG. 3 is a schematic, sectional view of an organic light emitting device according to another embodiment of the present invention;

FIG. 4 is a schematic, sectional view of an organic light emitting device according to another embodiment of the present invention; and

FIG. 5 is a schematic, sectional view of an organic light emitting device according to another embodiment of the present invention.

### DETAILED DESCRIPTION

In the following detailed description, only certain embodiments of the present invention are shown and described, by way of illustration. As those skilled in the art would recognize, the invention may be embodied in many different forms and should not be construed as being limited to the embodiments set forth herein. Also, in the context of the present application, when an element is referred to as being "on" another element, it can be directly on the another element or be indirectly on the another element with one or more intervening elements interposed therebetween. Like reference numerals designate like elements throughout the specification.

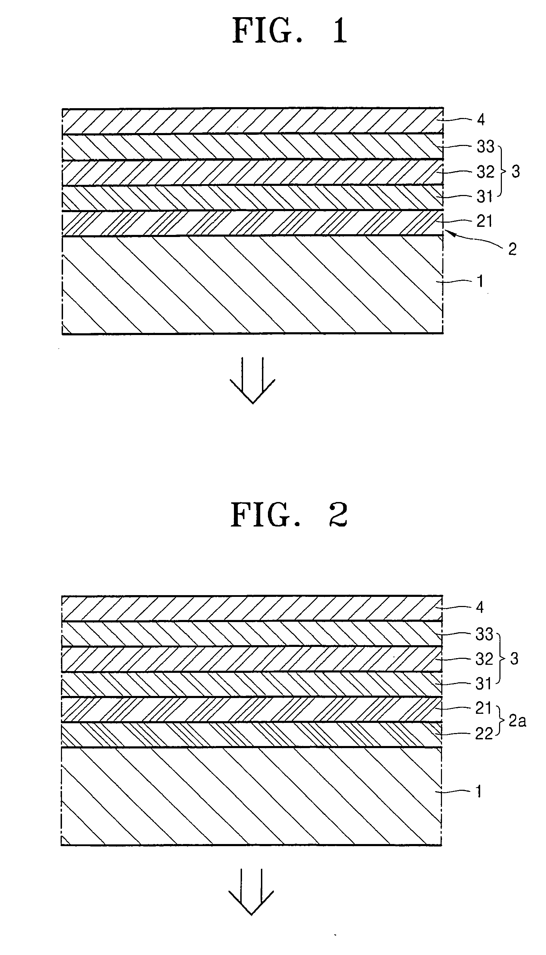

FIG. 1 is a schematic, sectional view of an organic light emitting device according to an embodiment of the present invention.

Referring to FIG. 1, the organic light emitting device has a structure in which an anode 2, an organic layer 3, and a cathode 4 are sequentially stacked on a substrate 1.

In the organic light emitting device of FIG. 1, light is generated in the organic layer 3 when holes are provided from the anode 2 to the organic layer 3, and electrons are provided from the cathode 4 to the organic layer 3. The light emitted from the organic layer 3 is transmitted toward the substrate 1, that is, in a direction illustrated by an arrow in FIG. 1, thereby forming images that are displayed under the substrate 1.
An organic light emitting device having the structure described above is referred to as a bottom-emission type organic light emitting device.

The substrate 1 can be formed of glass and/or plastic. A plurality of pixel circuits including a thin film transistor and a capacitor can be formed on the substrate 1 and each pixel circuit may be connected to the anode 2.

The anode 2 formed on the substrate 1 is connected to an external power source, provides holes to the organic layer 3, and includes a first layer 21 formed by co-depositing a first metal oxide and a second metal oxide on the substrate 1. The first layer 21 will be described in more detail below.

The organic layer 3 is formed on the anode 2. In the organic layer 3, holes and electrons respectively provided by the anode 2 and the cathode 4 are combined together to generate excitons, thereby emitting light.

The organic layer 3 includes at least an emission layer 32, and also may include a first intermediate layer 31 that can be interposed between the emission layer 32 and the anode 2, and a second intermediate layer 33 that can be interposed between the emission layer 32 and the cathode 4.

The first intermediate layer 31 may include a hole injection layer, a hole transport layer, etc. However, the structure of the first intermediate layer 31 is not limited thereto. For example, the first intermediate layer 31 can be a single layer selected from the layers described above, or further include an electron blocking layer. The second intermediate layer 33 may include an electron transport layer, an electron injection layer, etc. However, the structure of the second intermediate layer 33 is not limited thereto. For example, the second intermediate layer 33 can be a single layer selected from the layers described above, or further include a hole blocking layer.

The emission layer 32 may be formed of any suitable emission layer forming material. For example, the emission layer 32 can be formed of oxadiazole dimer dyes (Bis-DAPOXP), spiro compounds (Spiro-DPVBi, Spiro-6P), triarylamine compounds, bis styryl amine (DPVBi, DSA), Flrpic, CzTT, anthracene, TPB, PPCP, DST, TPA, OXD-4, BBOT, AZM-Zn, etc. (to obtain blue light); Coumarin 6 , C545T, Quinacridone , lr(ppy)3, etc. (to obtain green light); and DCM1, DCM2, Eu(thenoyltrifluoroacetone)3 (Eu(TTA)3), butyl-6- (1,1,7,7,-tetramethyljulolidyl-9-enyl)-4H-pyran (DCJTB), etc. (to obtain red right). The emission layer 32 can also be formed of at least one polymer selected from the group consisting of a polyphenylenevinylene (PPV)-based polymer and derivatives thereof, a polyphenylene (PPP)-based polymer and derivatives thereof, a polythiophene (PT) based polymer and derivatives thereof, a polyfluorene (PF)-based polymer and derivatives thereof, and a polyspirofluorene (PSF)-based polymer and derivatives thereof.

The hole injection layer can be formed of copper phthalocyanine (CuPc); a starburst-type amine, such as TCTA, m-MTDATA, HI406 (produced by Idemitz Co.); and/or a water-soluble conductive polymer, such as polyaniline/dodecylbenzenesulfonic acid (Pani/DBSA), poly (3,4-ethylenedioxythiophene)/poly(4-styrenesulfonate) (PEDOT/PSS), polyaniline/camphor sulfonic acid (Pani/CSA), or polyaniline /poly(4-styrenesulfonate) (PANI/PSS), but is not particularly limited thereto.

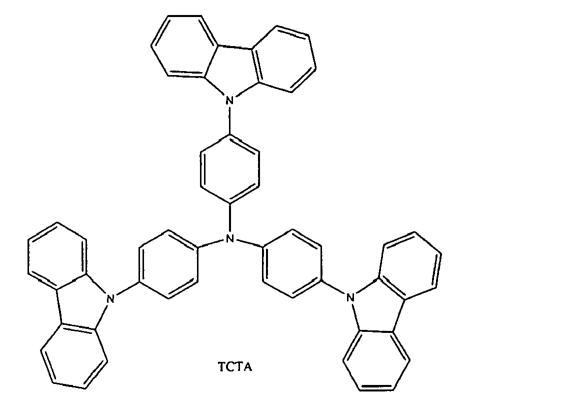

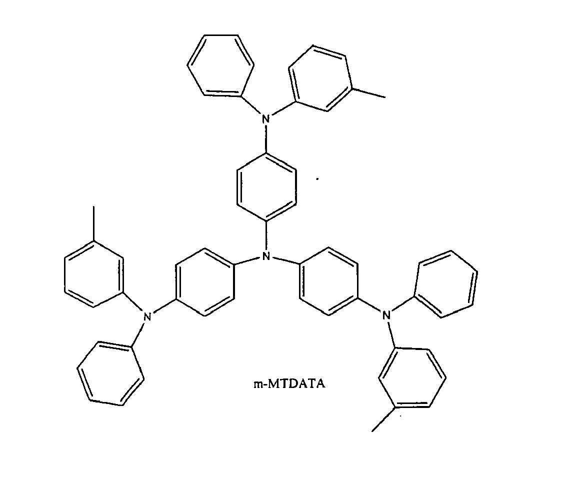

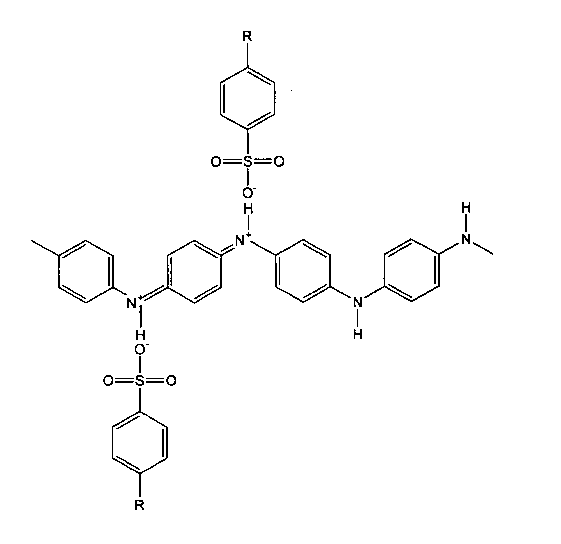

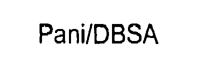

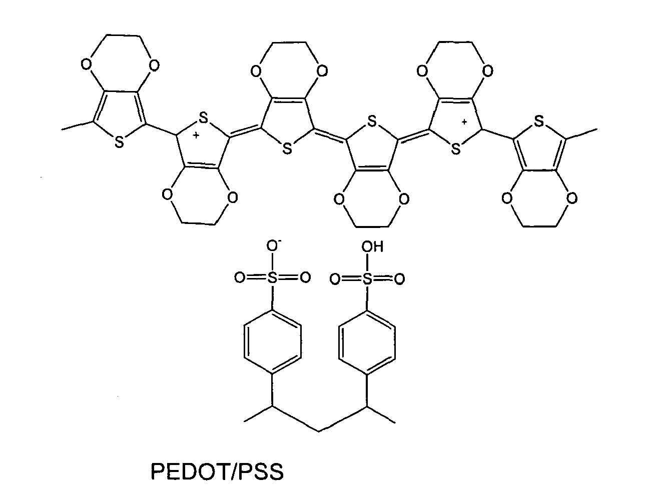

PEDOT/PSS is a very stable material that retains a constant conductivity even when left to sit for 100-1000 hours in air. In particular, the hole injection layer can be formed using PEDOT/PSS, that is, PEDOT/PSS is dissolved in a solvent such as water and/or alcohol and then the dissolved PEDOT/PSS is spin coated (e.g., spin coated on another layer to form the hole injection layer).

The hole transport layer may include a material selected from the group consisting of a compound having a carbazole group and/or arylamine group, a phthalocyanine-based compound, and a triphenylene derivative, each of which can transport holes, but is not particularly limited thereto. In particular, the hole transport layer may be formed of at least one material selected from the group consisting of 1,3,5-tricarbazolylbenzene, 4,4'-biscarbazolylbiphenyl, polyvinylcarbazole, m-biscarbazolylphenyl, 4,4'-biscarbazolyl-2,2'-dimethylbiphenyl, 4,4',4"-tri(N-carbazolyl)triphenylamine, 1,3,5-tri(2-carbazolylphenyl)benzene, 1,3,5-tris(2-carbazolyl-5-methoxyphenyl)benzene, bis(4-carbazolylphenyl)silane, N,N'-bis(3-methylphenyl)-N,N'-diphenyl-[1,1-biphenyl]-4,4'diamine (TPD), N,N'-di(naphthalene-1-yl)-N,N'-diphenyl benzidine (α-NPD), N,N'-diphenyl-N,N'-bis(1-naphthyl)-(1,1'-biphenyl)-4,4'-diamine (NPB), IDE320 (produced by Idemitz Co.), poly(9,9-dioctylfluorene-co-N-(4-butylphenyl)diphenylamine (TFB), poly(9,9-dioctylfluorene-co-bis-(4-butylphenyl-bis-N,N-phenyl-1,4-phenylenediamin)(PFB), poly(9,9-dioctylfluorene-co-bis-N,N-(4-butylphenyl)-bis-N,N-phenylbenzidine)(BFE), and combinations thereof. However, the hole transport layer can be formed of other suitable materials.

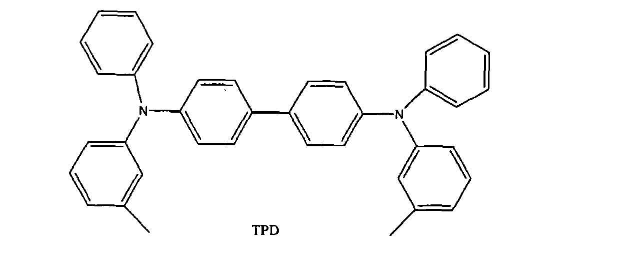

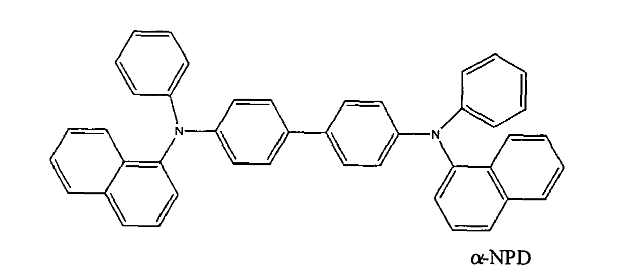

The electron transport layer may be formed by vacuum depositing and/or spin coating an electron transporting material on the emission layer 32. The electron transport material is not limited, and can include a compound suitable for utilization as electron transporting compounds, such as Alq3, rubrene, quinoline-based low and high weight molecular weight compounds, quinoxaline-based low and high weight molecular weight compounds, etc. In addition, the electron transport layer can be a multi-layered structure formed of at least two different layers.

The electron injection layer can be formed by performing a vacuum deposition process and/or a spin coating process on the electron transport layer. A material used to form the electron injection layer can be BaF₂, LiF, NaF, MgF₂, AlF₃, CaF₂, NaCl, CSF, Li₂O, BaO, Liq, etc., but is not limited thereto.

The cathode 4 may be formed of a material selected from the group consisting of Ag, Mg, Al, Pt, Pd, Au, Ni, Nd, lr, Cr, and compounds thereof, so that the cathode 4 can reflect light emitted from the emission layer 32 and has a smaller absolute work function value than that of the anode 2 and thus electrons can be easily injected by the cathode 4. In one embodiment, the cathode 4 is formed of Al.

According to an embodiment of the present invention, the first layer 21 included in the anode 2 includes a first metal oxide and a second metal oxide as described above. The first metal oxide may include indium oxide, indium tin oxide, zinc oxide, indium zinc oxide, tin oxide, antimony tin oxide, antimony zinc oxide, and/or aluminum oxide. The second metal oxide may include ytterbium oxide (YbO), lanthanum oxide (La₂O₃), yttrium oxide (Y₂O₃), beryllium oxide (BeO), titanium oxide (TiO), silicon oxide (SiO₂), gallium oxide (Ga₂O₃), palladium oxide (PdO), and/or samarium oxide (Sm₂O₃).

According to an embodiment of the present invention, the first metal oxide can be indium oxide (InOₓ), and the second metal oxide can be ytterbium oxide (YbO).

The second metal oxide has an absolute work function value of about 6.0 eV or more in order to substantially function as (or become) an insulator. On the other hand, the first metal oxide has a relatively smaller absolute work function value than the second metal oxide, so that the first metal oxide has conductivity higher than that of the second metal oxide. In the current embodiment, indium oxide is thermally evaporated to form a transparent electrode having an absolute work function value ranging from about 4.8 to about 5.0 eV and a light transmissivity of about 90% or more. Then, ytterbium oxide (YbO) is co-deposited. Here, a few percent (%) to tens of percent (%) of ytterbium (Yb) can be doped, so that the absolute work function value of the first layer 21 can be increased to as high as a value ranging from about 5.1 to about 5.8 eV.

Specifically, indium oxide is thermally evaporated in a chamber in which plasma has been formed so that the deposition temperature can be decreased. When the thermal evaporation process is performed in a chamber in which plasma has been formed, effective deposition can be obtained while the deposition temperature is not increased. As described above, when indium oxide is thermally evaporated in a chamber in which a plasma has been already formed, the temperature of the substrate 1 may only need to be increased to as low as about 100°C. Here, the formed indium oxide has excellent mobility, and thus its resistance is very low.

According to a conventional thermal evaporation process, the temperature is increased to a melting point or sublimation point of a source material or higher to form a layer. However, a layer formed according to the conventional thermal evaporation process has lower reactivity and mobility compared to sputtering and/or e-beam processes, and thus the conventional thermal evaporation process is used only in a general metal deposition process not used in a thin film deposition process. In particular, as for a material used to form a transparent electrode, the temperature of a substrate should be increased to a temperature ranging from as high as from 250 to 300°C to obtain sufficiently low resistance and transmissivity properties.

However, according to the current embodiment, weak plasma surrounds a thermal source and ionizes a metal to be deposited in a chamber, and thus a mobility property required to act as an electrode and light transmissivity can be obtained.

In the case of the indium oxide according to the current embodiment, indium (In) or indium oxide In₂O₃ in pellet or wire form can be used as a thermal source that can be formed into an indium oxide (InOₓ) layer in an oxygen atmosphere. Plasma which is used to ionize indium metal can be formed using at least one of Ar gas or O₂ gas. The temperature of the substrate is increased from room temperature to 100°C.

When the indium oxide layer is formed as described above, a transparent electrode having light transmissivity of 90% or higher can be obtained, and the formed indium oxide layer has an absolute work function value ranging from 4.8 to 5.0 eV.

In the current embodiment, when the indium oxide layer is formed, a few % to tens of % of ytterbium (Yb) is doped into the indium oxide layer by co-depositing ytterbium oxide (YbO). As a result, the formed first layer 21 has an absolute work function value ranging from as high as 5.1 to 5.8 eV. In addition, the amount of ytterbium oxide (YbO) to be co-deposited can be controlled, so that a desired work function and low resistance suitable for functioning (or acting) as an electrode can be obtained. As illustrated in FIG. 1, the anode 2 may include only the first layer 21. In this case, the first layer 21 acting as the anode 2 has a large absolute work function value, so that even when the cathode 4 has a larger absolute work function value than that of a conventional cathode, an organic light emitting device can still be realized (or manufactured). In a bottom emission type structure, the work function value of the cathode is regarded as a less important factor. Also, in the bottom emission type structure as illustrated in FIG. 1, the first layer 21 has as much as 90% light transmissivity, while a typical ITO layer has light transmissivity of about 45%. As a result, relatively high light emission efficiency can be obtained. In addition, when the first layer 21 acts as the anode 2, there is no need to perform a UV-O₃ treatment and/or plasma treatment, which is performed on the ITO layer acting as an anode in a conventional bottom emission type structure, to increase the absolute work function value. Furthermore, by controlling the work function of the first layer 21, a hole injection layer may not need to be formed in the first intermediate layer 31, so that an organic light emitting device having a relatively simple structure can be obtained using a relatively simple process.

FIG. 2 is a schematic, sectional view of an organic light emitting device according to another embodiment of the present invention. Referring to FIG. 2, a second layer 22 is formed on a substrate 1, and a first layer 21 is formed on the second layer 22. The first layer 21 and the second layer 22 constitute an anode 2a. The organic light emitting device illustrated in FIG. 2 has a bottom emission type structure in which images formed are displayed at the bottom of the substrate 1. Other elements in the current embodiment that are similar to (or substantially the same as) the elements in the organic light emitting device illustrated in FIG. 1 will not be described again. The first layer 21 and the second layer 22 will now be described in more detail.

Like a conventional anode, the second layer 22 formed on the substrate 1 may be formed of indium oxide, indium tin oxide, zinc oxide, indium zinc oxide, tin oxide, antimony tin oxide, antimony zinc oxide, aluminum oxide and combinations thereof. In the current embodiment, the second layer 22 can be formed of indium tin oxide (ITO). The second layer 22 may have an absolute work function value ranging from about 5.1 to about 5.4 eV, and a surface resistance of about 10 Ω/m² or lower, which is sufficient for use as an anode.

The first layer 21 acting as an anode assistant electrode is formed on the second layer 22. The first layer 21 includes a first metal oxide and a second metal oxide, as described in the previous embodiment. The first metal oxide may include indium oxide, indium tin oxide, zinc oxide, indium zinc oxide, tin oxide, antimony tin oxide, antimony zinc oxide, and/or aluminum oxide. The second metal oxide may include ytterbium oxide (YbO), lanthanum oxide (La₂O₃), yttrium oxide (Y₂O₃), beryllium oxide (BeO), titanium oxide (TiO), silicon oxide (SiO₂), gallium oxide (Ga₂O₃), palladium oxide (PdO), and/or samarium oxide (Sm₂O₃). In the current embodiment, the first metal oxide is indium oxide (InOₓ), and the second metal oxide is ytterbium oxide (YbO.) The first and second metal oxides can be used in the same (or substantially the same) manner as described in the previous embodiment.

Unlike in the previous embodiment, there is no need to decrease resistance since the first layer 21 is used as an anode assistant electrode. The first layer 21 can sufficiently act as an anode assistant electrode by controlling the work function thereof. In addition, a hole injection layer may not be required to be formed in the first intermediate layer 31 by controlling the work function of the first layer 21.

In the current embodiment, the first layer 21 has a relatively high light transmissivity as described above, so that light emission efficiency can be improved as compared to a conventional device by controlling the thickness of the second layer 22.

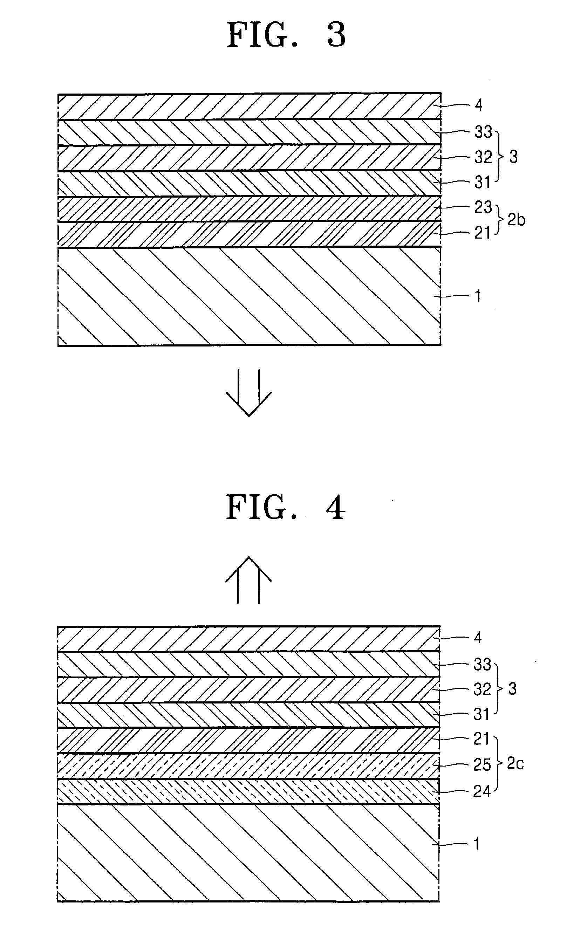

FIG. 3 is a schematic, sectional view of an organic light emitting device according to another embodiment of the present invention. Referring to FIG. 3, a first layer 21 is formed on a substrate 1, and a third layer 23 is formed on the first layer 21. The first layer 21 and the third layer 23 constitute an anode 2b. The organic light emitting device illustrated in FIG. 3 has a bottom emission type structure in which images formed are displayed at the bottom of the substrate 1. Other elements in the current embodiment that are similar to (or substantially the same as) the elements in the organic light emitting device illustrated in FIG. 1 will not be described again. The first layer 21 and the third layer 23 will now be described in more detail.

In the current embodiment described with reference to FIG. 3, the first layer 21 has low resistance to act as an electrode as in the previous embodiment described with reference to FIG. 1. The third layer 23 acts as an anode assistant electrode, and can be formed of molybdenum oxide, vanadium oxide, tungsten oxide, nickel oxide, and/or copper oxide; and/or fullerene, metal-containing fullerene-based complex, carbon nano tube, carbon fiber, carbon black, graphite, carbine, MgC₆₀, SrC₆₀, CaC₆₀, and/or C₆₀. Here, the first layer 21 may have a relatively low resistance by controlling a doping concentration of ytterbium as described above and the third layer 23 can be used to control the work function to form the anode 2b of an organic light emitting device.

The organic light emitting devices described in the previous embodiments, which are bottom emission type organic light emitting devices, can operate according to a passive matrix (PM) driving method or an active matrix (AM) driving method.

When the organic light emitting devices operate according to a PM driving method, the anode 2, 2a, 2b may be disposed to cross (e.g., be perpendicular to) the cathode 4 so that a strip pattern is formed, and an emission pixel can be realized at an area in which the anode 2, 2a, 2b and the cathode 4 cross.

When the organic light emitting devices operate according to an AM driving method, a pixel circuit unit includes one or more thin film transistors formed between the substrate 1 and the anode 2, 2a, 2b, and the anode 2, 2a, 2b of each pixel is electrically connected to a corresponding pixel circuit.

An organic light emitting device having a top emission type structure according to an embodiment of the present invention will now be described in more detail.

FIG. 4 is a schematic, sectional view of a top emission type organic light emitting device according to an embodiment of the present invention. Referring to FIG. 4, a fourth layer 24, a reflective layer 25, and a first layer 21 are sequentially formed on a substrate 1 to form an anode 2c. An organic layer 3 and a cathode 4 are formed on the anode 2c.

The fourth layer 24 formed on the substrate 1 may be formed of indium oxide, indium tin oxide, zinc oxide, indium zinc oxide, tin oxide, antimony tin oxide, antimony zinc oxide, and/or aluminum oxide, each of which can be used to form a reflective anode. The reflective layer 25 may be formed of a material selected from the group consisting of Ag, Mg, Al, Pt, Pd, Au, Ni, Nd, Ir, Cr, and compounds thereof.

The first layer 21 as described above is formed on the reflective layer 25. The first layer 21 can be formed using the same (or substantially the same) material and the same (or substantially the same) manufacturing method as in the previous embodiments. Here, the first layer 21 may have low resistance as in the embodiment described according to FIG. 1 to function as an anode.

In this embodiment, the fourth layer 24 is formed of ITO, the reflective layer 25 is formed of Ag, and the first layer 21 is formed of InOₓ that is co-deposited with YbO. As a result, the anode 2 has a sequential stacked structure of ITO/Ag/InOₓ:YbO. Also, according to a design condition, the fourth layer 24 may not be needed to be formed.

In the top emission type organic light emitting device described above, the first layer 21 has a relatively large absolute work function value and thus has a degree of freedom, with respect to selection of a material used to form the cathode 4, that can be increased.

That is, in consideration of structural properties of an organic light emitting device, a cathode material should have a small absolute work function value as compared to an anode material. Accordingly, in a conventional organic light emitting device, when an anode is formed of ITO and when a cathode is formed of Al, the work functions of the anode and the cathode are balanced together. In a top emission type structure in which an image is displayed in a direction of (or through) a cathode, the cathode formed of Al has low light transmissivity. Accordingly, in a conventional top emission type structure, a cathode includes a Mg:Ag thin layer, which is a semi-transparent layer, to balance the work functions of the cathode and an anode, and an oxide layer formed of, for example ITO, to compensate for low conductivity due to use of the semi-transparent layer. However, the Mg:Ag semi-transparent layer has low light transmissivity and low layer uniformity. In addition, even when an oxide formed of, for example, ITO, is used, the light transmissivity remains as low as less than 50%. As a result, it is difficult to form a transparent cathode.

According to embodiments of the present invention, an anode has a relatively large absolute work function value, and thus, even when a cathode used has a relatively larger absolute work function value than that of a conventional cathode, the work function of the cathode can be balanced with the work function of the anode. As a result, the cathode forming material can be selected with less limitation.

In the current embodiment described with reference to FIG. 4, the anode 2c has the sequential stacked layer structure of ITO/Ag/InO,:YbO, so that the first layer 21 has an absolute work function value ranging from about 5.1 to about 5.8 eV.

Accordingly, any material having an absolute work function value less than that of the first layer 21 can be used to form the cathode 4. As a result, the cathode 4 of FIG. 4 can be formed of a material having an absolute work function value ranging from about 4.8 to about 5.0 (or from 4.8 to 5.0), such as indium oxide (InOₓ) which can be thermally evaporated in a plasma atmosphere as described above with reference to FIG. 1 (e.g., with respect to the first metal oxide of FIG. 1). In this case, the InOₓ layer shows light transmissivity of 90% or higher, and thus is suitable for forming the cathode 4 to be transparent.

However, the cathode 4 is not necessarily limited thereto, and may include a metal oxide layer formed of indium oxide, indium tin oxide, zinc oxide, indium zinc oxide, tin oxide, antimony tin oxide, antimony zinc oxide, and/or aluminum oxide; and/or further includes a semi-transparent layer formed of a material selected from the group consisting of Ag, Mg, Al, Pt, Pd, Au, Ni, Nd, Ir, Cr, and compounds thereof between the metal oxide layer and the second intermediate layer 33.

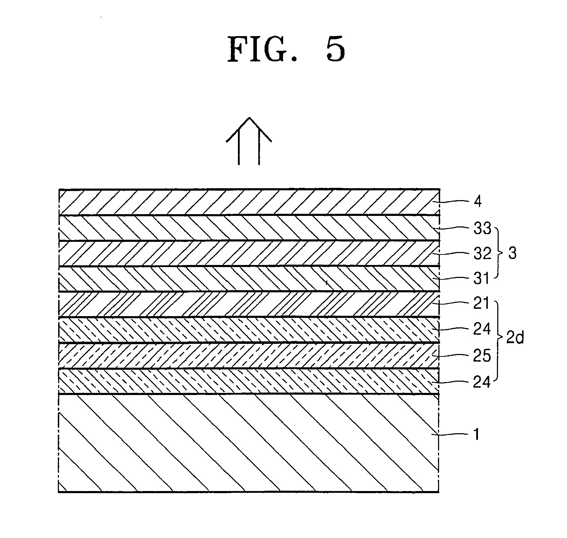

FIG. 5 is a schematic, sectional view of a top emission type organic light emitting device according to another embodiment of the present invention. Referring to FIG. 5, the top emission type organic light emitting device according to the current embodiment has a structure in which an anode 2d having a stacked structure including a first fourth layer 24, a reflective layer 25, and another fourth layer 24 that are sequentially deposited on a substrate 1, and a first layer 21 acting (or being utilized) as an assistant electrode is disposed on the stacked structure. Here, unlike in the embodiment described with reference to FIG. 2, the stacked structure of the anode 2d by itself does not act as an electrode. Therefore, there is not a need for the stacked structure of the anode 2d to be formed with a low resistance layer, which is required to act as an electrode. That is, an organic light emitting device according to the current embodiment can be produced by forming the first layer 21 to act (or to be utilized) as an anode assistant electrode between an anode and organic layer of a conventional organic light emitting device.

In the embodiments described with reference to FIG. 4 and FIG. 5, the first intermediate layer 31 may not need a hole injection layer due to controlling the work function of the first layer 21. The organic light emitting devices according to the embodiments described with reference to FIG. 4 and FIG. 5 can operate using a passive matrix (PM) driving method or active matrix (AM) driving method.

As described above, according to embodiments of the present invention, an anode having desired properties can be obtained by controlling its work function, and a surface treatment process used to increase the work function of the anode, is not required. Thus, the process of manufacturing an organic light emitting device including the anode can be simplified.

In addition, a hole injection layer is not needed due to controlling the work function of the anode, so that the manufacturing process is lowered in cost and simplified, and thus a relatively high manufacturing yield can be obtained.

Furthermore, a degree of freedom with respect to selection of a cathode forming material can be increased, so that various suitable materials can be easily used to form the cathode.

While the present invention has been described in connection with certain embodiments, it is to be understood that the invention is not limited to the disclosed embodiments, but, on the contrary, is intended to cover various modifications and equivalent arrangements included within the scope of the appended claims, and equivalents thereof.

## Claims

1. An organic light emitting device comprising:
an anode comprising a first layer, the first layer comprising a first metal oxide and a second metal oxide, the second metal oxide differing from the first metal oxide and doped into the first metal oxide;
a cathode facing the anode; and
an organic layer comprising an emission layer between the anode and the cathode.

2. An organic light emitting device according to claim 1, wherein the anode further comprises a second layer comprising a material selected from the group consisting of indium oxide, indium tin oxide, zinc oxide, indium zinc oxide, tin oxide, antimony tin oxide, antimony zinc oxide, aluminum oxide, and combinations thereof.

3. An organic light emitting device according to claim 1, wherein the anode further comprises a third layer comprising a material selected from the group consisting of molybdenum oxide, vanadium oxide, tungsten oxide, nickel oxide, copper oxide, fullerene, metal-containing fullerene-based complex, carbon nano tube, carbon fiber, carbon black, graphite, carbine, MgC₆₀, SrC₆₀, CaC₆₀, C₆₀, and combinations thereof.

4. An organic light emitting device according to one of claims 1 to 3,
wherein the cathode comprises a material selected from the group consisting of Ag, Mg, Al, Pt, Pd, Au, Ni, Nd, Ir, Cr, and compounds thereof.

5. An organic light emitting device according to claim 1, wherein the anode further comprises a reflective layer comprising a material selected from the group consisting of Ag, Mg, Al, Pt, Pd, Au, Ni, Nd, Ir, Cr, and compounds thereof.

6. An organic light emitting device according to claim 5, wherein the anode further comprises a second layer comprising a material selected from the group consisting of indium oxide, indium tin oxide, zinc oxide, indium zinc oxide, tin oxide, antimony tin oxide, antimony zinc oxide, aluminum oxide, and combinations thereof.

7. An organic light emitting device according to claim 6, wherein the reflective layer is between the first layer and the second layer.

8. An organic light emitting device according to claim 6, wherein the anode comprises a third layer comprising a material selected from the group consisting of indium oxide, indium tin oxide, zinc oxide, indium zinc oxide, tin oxide, antimony tin oxide, antimony zinc oxide, aluminum oxide, and combinations thereof; and wherein the second layer is between the first layer and the reflective layer, and wherein the reflective layer is between the second layer and the third layer.

9. An organic light emitting device according to claim 8, wherein, the second layer is substantially the same in material composition as the third layer.

10. An organic light emitting device according to one of claims 1 and 5 to 9,
wherein the cathode comprises a material selected from the group consisting of indium oxide, indium tin oxide, zinc oxide, indium zinc oxide, tin oxide, antimony tin oxide, antimony zinc oxide, aluminum oxide, and combinations thereof.

11. An organic light emitting device according to any preceding claim,
wherein the first metal oxide comprises a material selected from the group consisting of indium oxide, indium tin oxide, zinc oxide, indium zinc oxide, tin oxide, antimony tin oxide, antimony zinc oxide, aluminum oxide, and combinations thereof.

12. An organic light emitting device according to any preceding claim,
wherein the second metal oxide comprises a material selected from the group consisting of ytterbium oxide, lanthanum oxide, yttrium oxide, beryllium oxide, titanium oxide, silicon oxide, gallium oxide, palladium oxide, samarium oxide, and combination thereof.

13. A method of manufacturing an organic light emitting device, the method comprising:
forming an anode;
forming an intermediate layer comprising an emission layer on the anode; and
forming a cathode on the intermediate layer,
wherein the forming the anode comprises forming a first layer to include a first metal oxide and a second metal oxide differing from the first metal oxide, and wherein the forming the first layer comprises depositing the first metal oxide and doping a portion of the first metal oxide to form the second metal oxide.

14. A method according to claim 13, wherein the first metal oxide comprises a material selected from the group consisting of indium oxide, indium tin oxide, zinc oxide, indium zinc oxide, tin oxide, antimony tin oxide, antimony zinc oxide, aluminum oxide, and combinations thereof.

15. A method according to one of claims 13 or 14, wherein the second metal oxide comprises a material selected from the group consisting of ytterbium oxide, lanthanum oxide, yttrium oxide, beryllium oxide, titanium oxide, silicon oxide, gallium oxide, palladium oxide, samarium oxide, and combinations thereof.

16. A method according to one of claims 13 to 15, wherein the depositing the first metal oxide comprises plasma ionizing a metal to be deposited as the first metal oxide.

17. A method according to claim 16, wherein the doping the portion of the first metal oxide to form the second metal oxide comprises co-depositing a dopant into the first metal oxide.
